(19) Europäisches Patentamt European Patent Office Office européen des brevets

(11) **EP 3 185 026 B1**

(12) **EUROPEAN PATENT SPECIFICATION**

(45) Date of publication and mention of the grant of the patent:
**28.10.2020 Bulletin 2020/44**

(51) Int Cl.:
***G01R 31/28*** *(2006.01)*    ***G01R 1/073*** *(2006.01)*

(21) Application number: **15202281.0**

(22) Date of filing: **23.12.2015**

(54) **PROBING DEVICE FOR TESTING INTEGRATED CIRCUITS**

SONDIERUNGSVORRICHTUNG ZUM PRÜFEN INTEGRIERTER SCHALTUNGEN

DISPOSITIF DE SONDE POUR TESTER DES CIRCUITS INTÉGRÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**28.06.2017 Bulletin 2017/26**

(73) Proprietor: **IMEC VZW**
**3001 Leuven (BE)**

(72) Inventors:
• **Wang, Teng**
**3001 Leuven (BE)**
• **Marinissen, Erik Jan**
**3001 Leuven (BE)**
• **Beyne, Eric**
**3001 Leuven (BE)**

(74) Representative: **Patent Department IMEC**
**IMEC vzw**
**Patent Department**
**Kapeldreef 75**
**3001 Leuven (BE)**

(56) References cited:
**US-A- 5 434 513**    **US-A- 6 137 299**
**US-A1- 2004 032 271**    **US-A1- 2008 054 917**
**US-A1- 2011 043 233**    **US-A1- 2013 063 172**

## Description

## Field of the Invention

The present invention is related to electrical testing of ICs by probing an array of fine-pitch contact pads or (micro)bumps on the IC.

## State of the art.

The difficulties of large-array fine-pitch probing include: construction of an array of probes that matches the ever-shrinking size and pitch of micro-bumps, alignment of the probes to the bumps, possible damage of the bumps caused by probing, fan-out routing from the large array of probes to electrical test equipment, and durability of the fine-pitch probes after repeated usage.

Conventional cantilever probe technology today is feasible down to 20 $\mu$m pitch arrays of contact pads or bumps on the IC under test. Unfortunately, the cantilever beams prevent the construction of arbitrary arrays of probes, because the configuration is restricted to two rows or four staggered rows. Vertical probe cards allow the construction of arbitrary arrays. Unfortunately, vertical probe cards (including advanced MEMS probe cards) are limited to minimum 40 $\mu$m pitch.

Another problem is related to the accuracy of the probe stations used for placing probe cards onto the device under test. Today's "probe-to-pad alignment" (PTPA) accuracy of state-of-the-art probe stations is +/- 1.8$\mu$m. If the micro-bump pitch is 20$\mu$m and the bump diameter is about 10$\mu$m, that starts to become a bottleneck.

Document US2004/0032271 discloses an anisotropic probing contactor consisting of a flexible insulator sheet with an array of parallel conducting probes running from one surface of the sheet to the opposite surface. The pitch of the probes is smaller than the pitch of the bumps on a device under test, so each bump is contacted by a plurality of probes. The contactor is placed between the contacts of an IC under test and a tester input board with the same number of contacts facing the contacts on the IC under test. An advantage of this contactor is that careful alignment with the IC under test is not necessary. If the diameter of the probes can be made small enough, this contactor could be used for testing IC's with micro-bumps with a pitch smaller than 40 $\mu$m. A disadvantage here is that the contactor has to be used with a tester input board that is specific for each IC under test.

## Summary of the invention

The invention is related to a probing device as disclosed in the appended claims. The device comprises a semiconductor substrate and an anisotropically conducting contactor attached to the substrate. The substrate comprises an integrated circuit portion comprising an array of contact pads on the surface of the substrate. The contactor is attached to the array of pads and comprises an array of probes, each probe being in contact with one pad. The IC portion comprises circuitry for selecting a number of probes and connecting the selected probes to an I/O terminal of the device, for connection to test equipment. According to a particular embodiment, the anisotropically conducting contactor comprises a multitude of nano-scaled conductors embedded in an insulating matrix, so that each probe is formed by a plurality of nano-scaled conductors.

The invention is thus related to a probing device for electrical testing of an integrated circuit, the IC to be tested comprising an array of contact structures, the probing device comprising :

- a semiconductor substrate comprising a plurality of input/output (I/O) terminals and an integrated circuit (IC) portion comprising an array of contact pads on a surface of the substrate,
- a contactor attached to the IC portion of the substrate, the contactor comprising an attachment surface and a contact surface, and an array of conductive probes extending between the two surfaces, the array of probes being in physical and electrical contact with the array of contact pads, and wherein the contact surface of the contactor is configured to be placed on the IC to be tested by establishing a physical and electrical contact between the contact structures on the IC to be tested and a number of the probes,

wherein the IC portion of the substrate comprises circuitry for selecting individual probes and establishing a connection between a selected probe and one or more I/O terminals. The attachment surface and the contact surface are preferably mutually parallel.

According to an embodiment, a number of adjacent probes are grouped in a number of unit cells, and the IC portion comprises a selection circuit for each unit cell, for selecting individual probes in each unit cell and establishing a connection between a selected probe and one or more I/O terminals .

The selection circuit may comprise a multiplexed array of pass gates, a pass-gate being connected between each of the probes and one or more I/O terminals, wherein the substrate comprises input terminals and selection signal lines for carrying a set of digital selection signals to the selection circuit. In the latter embodiment, the substrate may comprise selection signal lines which are common to several unit cells, so that one set of selection signals may be used to select probes in a plurality of the selection circuits.

According to an embodiment, the IC portion of the substrate further comprises circuitry for enabling the interconnection of several selected probes.

According to an embodiment, the contactor comprises a plurality of nano-scaled electrical conductors oriented along the same direction, and extending between the attachment surface and the contact surface, the conductors being embedded in a matrix of an electrically insulating material, so that the contactor is electrically conductive only in the direction of the conductors, the attachment surface of the contactor being attached to the IC portion of the substrate so that a plurality of conductors is in physical and electrical contact with each of the contact pads, each plurality of contacting conductors forming a probe extending between the two surfaces of the contactor. The nano-scaled conductors are preferably oriented perpendicularly to the attachment surface. The term 'nano-scaled' means that the diameter (or equivalent dimension) of the conductors is in the order of nanometers or tens of nanometers, for example between 10 and 100 nanometers.

According to an embodiment, the conductors are carbon nanotubes embedded in a polymer matrix. According to another embodiment, the conductors are gold wires embedded in a matrix of anodic aluminium oxide

The substrate may comprise marks which are detectable by an optical or infrared detector. The IC portion of the substrate may comprise a plurality of pressure sensors, each pressure sensor being configured to detect a pressure exerted on one of the probes.

According to an embodiment, several unit cells are grouped in unit blocks, and the IC portion comprises a selection circuit for each unit block.

The invention is equally related to a method for testing an integrated circuit under test by a probing device according to the invention, the IC under test comprising an array of contact structures having a given pitch, wherein the pitch of the array of probes is smaller than the pitch of the array of contact structures on the IC to be tested, so that at least one probe lands on a contact structure when the probing device is placed on the IC to be tested.

The invention is equally related to a kit of parts comprising :

• One or more ICs to be tested, each IC comprising an array of contact structures, the array being defined by a given pitch,
• a probing device according to the invention, wherein the pitch of the array of probes in the contactor of the probing device is smaller than the pitch of the array of contact structures of the one or more ICs to be tested, so that at least one probe lands on a contact structure when the probing device is placed on the IC to be tested.

According to an embodiment of said kit of parts, the spacing between the I/O terminals on the probing device is wider than the spacing between the contact structures on the ICs to be tested.

The invention is equally related to a method for determining which probes are in physical contact with the contact structures of an IC under test, when the probing device according to the invention is placed on the IC, the method comprising the steps of

- electrically shorting two contact structures,
- selecting pairs of probes on the probing device, and checking whether the probes of the selected pair are shorted,
- if the probes are shorted, concluding that the selected probes are in physical and electrical contact with the shorted contact structures.

The invention is equally related to a method for determining which probes are in physical contact with the contact structures of an IC under test, when the probing device according to the invention and provided with marks which are detectable by an optical detector, is placed on the IC, the method comprising the steps of

- detecting one or more marks on the probing device,
- detecting one or more marks on the IC under test,
- determining the distance between the marks on the probing device and the marks on the IC under test,
- determining on the basis of said distance which probes are in contact with one of the contact structures of the IC under test.

The invention is equally related to method for determining which probes are in physical contact with the contact structures of an IC under test, when the probing device according the invention and provided with pressure sensors, is placed on the IC, the method comprising the steps of

- detecting the output of the pressure sensors,
- determining on the basis of said output which probes are in contact with one of the contact structures of the IC under test.

**Brief description of the figures**

Figure 1a illustrates a probing device according to an embodiment of the invention, placed on an integrated circuit chip to be tested. Figure 1b shows a top view of the location of the probes of the device with respect to the microbumps of the IC to be tested. Figures 2a-2b illustrate an embodiment wherein the probes are grouped in unit cells of 16 probes per unit cell.
Figure 3a illustrates an embodiment wherein the device comprises circuitry for enabling the interconnection of multiple probes. Figure 3b shows a possible embodiment of the programming circuitry.
Figure 4 shows an embodiment that is further equipped with pressure sensors attached to the probes of one unit cell.
Figure 5 shows an embodiment wherein an additional level of selection circuitry is integrated in the probing device.

Figure 6 shows an embodiment wherein the probes are formed by groups of nano-scaled conductors embedded in an non-conducting matrix.

Figure 7 illustrates a number of fabrication steps for producing a device according to Figure 6.

**Detailed description of the invention**

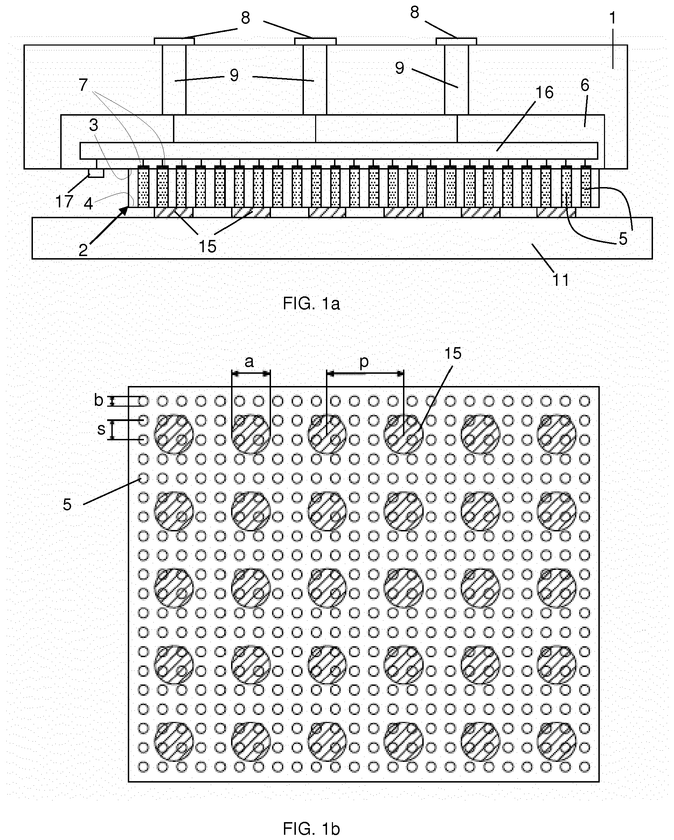

Figure 1a shows the probing device according to an embodiment of the invention. The device comprises a semiconductor substrate 1, preferably a silicon substrate, with an anisotropically conducting contactor 2 attached to the substrate. The anisotropically conducting contactor 2 has essentially parallel upper and lower surfaces 3 and 4, the upper surface 3 is referred to here as the attachment surface, the lower surface 4 as the contact surface. The contactor 2 comprises an array of electrically conducting probes 5 extending between the surfaces 3 and 4 of the contactor. The probes are electrically conducting in the vertical direction (when the contactor 2 is oriented horizontally), and not in the lateral direction, hence the term 'anisotropically conducting'. The contactor may comprise a block or sheet of non-electrically conducting material with the probes embedded in the non-conducting material. The contactor 2 as a whole preferably has a degree of compliance, enabling the contactor to be placed with a given pressure onto a device under test, with a slight elastic deformation of the contactor taking place, this to optimize the contact with the device under test (see further). To this aim, the non-conducting material is preferably a flexible material and the probes 5 as such as also elastically deformable. The substrate 1 comprises an integrated circuit (IC) portion 6 comprising an array of contact pads 7 at the surface of the substrate. The naming of portion 6 as 'IC portion' stems from the fact that this portion of the semiconductor substrate is obtainable by standard front-end-of-line (FEOL) and Back-end-of-line (BEOL) processing as generally known in the art. The array of probes 5 is physically and electrically connected to the array of contact pads 7, i.e. each probe 5 is in contact with a corresponding pad 7.

The IC portion 6 is connected to I/O terminals 8, for connection to test equipment (not shown). In the embodiment illustrated in Figure 1, the connection is established by TSV connections 9 through the substrate thickness. TSV is known to stand for 'through silicon via', but within the present context the material is not limited to silicon, so TSV may be defined as 'through semiconductor via' or 'through substrate via'. Alternatively or in combination with a number of TSVs 9, wire bonds may be applied to connect the IC portion 6 to I/O terminals on the same surface as the IC portion 6.

Figure 1a further illustrates that the probing device is configured to be placed on an array of contact structures 15 of a micro-electronic component, for example an integrated circuit chip 11 that is to be tested, so that the probes 5 are in electrical and physical contact with the contact structures 15. These contact structures may be a set of pads or micro-bumps of an integrated circuit chip under test, arranged at regular distances, for example in a regular array with a pitch lower than 20 micrometer. When the contactor 2 is compliant, elastic deformation of the contactor is enabled in the areas between the microbumps 15 (which may have a height between 5 and 10 micrometers) thereby ensuring optimal contact pressure between the probes 5 and the bumps 15. Compliance of the contactor 2 also allows placement of the contactor 2 onto an array of microbumps 15 with a variation in their height.

As seen in the drawing, the pitch between the pads 7 and thus between the probes 5 on the probing device is significantly lower than the pitch between the microbumps 15, thereby ensuring that there is always at least one complete probe 5 that lands on each bump 15. Also the size of the cross section of the probes 5, preferably circular in shape, is significantly smaller than the size of the bumps 15. In this way, the array of probes 5 overlaps the array of bumps 15 in the manner shown in Figure 1b. With b the diameter of the probes 5, a the diameter of the bumps 15, s the pitch of the probe array and p the pitch of the bump array, the following relationships define a preferred embodiment :

$$b < p - a \text{ and } b + \sqrt{2}s < a$$

Taking a design of s=2b, the second requirement can be simplified to $b < 0.26a$ or $s < 0.52a$. For convenience in the mapping step (described hereafter), it is preferable to design the probe pitch s as $\frac{1}{2i}$ ($i$ is an integer greater than 1) of the bump pitch $p$. Therefore, for most applications, s can be taken as 1/4 of $p$. A realistic example of the dimensions is : p = 20 $\mu$m, a= 10 $\mu$m, s = 5 $\mu$m, b = 2.5 $\mu$m.

Because of the significant difference between the pitches s and p, the probing device can be placed on the chip to be tested with only coarse accuracy, for example with an accuracy in the order of magnitude of the bump pitch p. Only a rotational alignment of the device may be required with respect to the IC under test, so that the directions of the rows and columns of the probe array are aligned with the directions of the rows and columns of the bump array. When a complete wafer is provided on which a plurality of ICs are to be tested, this rotational alignment has to be done only once, adding little time overhead to the complete test sequence.

Because the pads 7 are part of an integrated circuit portion 6 on the semiconductor substrate 1, they can be produced by standard Back-end-of-line processing techniques, involving single or double damascene fabrication of metallization layers, as known in the art. This makes it possible to produce the pads 7 at the required small pitch, which makes the device applicable to testing ICs which have microbumps at very fine pitch, e.g. down to 20 micrometer or less.

The IC portion 6 of the probing device of the invention further comprises circuitry 16 for selecting one or more of the pads 7 and thereby selecting the probes 5 in physical contact with said pads 7, and for connecting a selected probe 5 to an I/O terminal 8, while other probes are not connected to any I/O terminal. This makes it possible to supply or receive test signals only to or from a selected number of probes 5, namely the probes which are in contact with a microbump 15, as established by a mapping procedure of which examples will be given later in this text. The selection circuitry 16 comprises at least a set of micro-electronic switches, a switch being connected between each of the probes 5 and one or more I/O terminals 8. The switches allow the passage of analog signals to and from the probes 5. According to a preferred embodiment, these switches are so-called pass-gates, comprising parallel nMOS and pMOS transistors, as known in the art as such. Input terminals 17 and signal lines 18 are provided for supplying selection signals to the selection circuitry 16, for controlling the status of the switches. The selection circuitry 16 avoids the need to provide a separate I/O terminal for each probe 5.

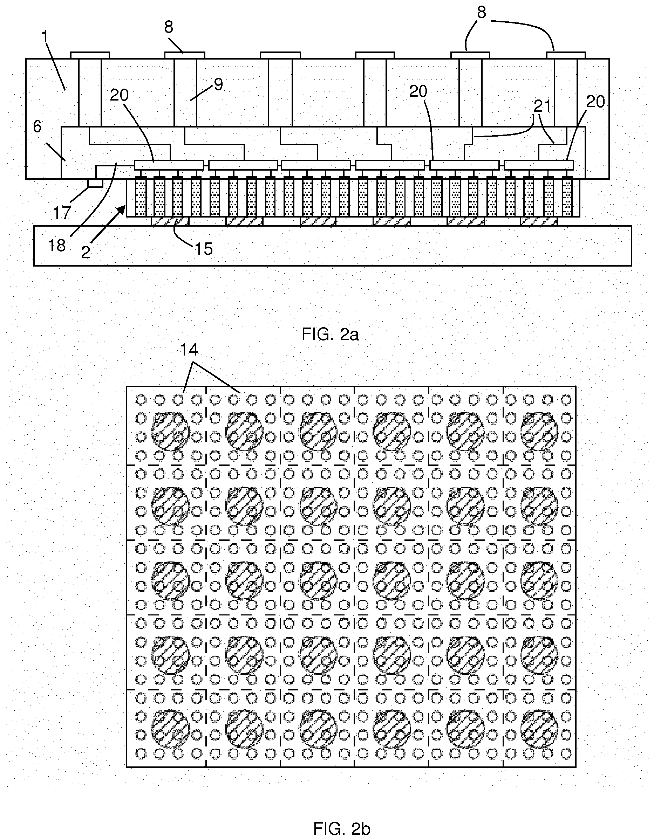

A preferred embodiment of the selection circuitry 16 is illustrated in Figures 2a and 2b. Each group of 16 probes arranged on a square area of the array is defined as a 'unit cell' 14, and provided with a selection circuit 20. The selection circuits 20 are thus an embodiment of the 'selection circuitry 16' shown in Figure 1a. Each unit cell 14 is placed above one microbump 15; due to the difference in pitch between the micro-bumps 15 and the probes 5, at least one probe 5 of each cell will automatically be contacting a bump. Each selection circuit 20 is configured as a multiplexed array of pass-gates, controlled by a set of 4 digital selection signals, allowing to select one of the 16 probes in each cell and - by selecting the probe - establish an analog signal connection between the selected probe and an input/output signal line 21 connected to an I/O terminal 8. The four digital selection signals can furthermore be shared by all the unit cells 14 of the probing device, so that four selection input terminals 17 are sufficient for selecting a probe in each unit cell. When the mapping between the probe array and the microbump array has been adequately established (determining which probes are in contact with which microbump), selection of probes is thereby done for all microbumps simultaneously, i.e. the same probe of the 16 in each unit cell is selected by a single set of digital signals on the four lines 21. According to other embodiments, more than 4 selection signals may be provided, allowing thereby to select multiple probes in each unit cell 14, thereby possibly reducing the contact resistance to the contact structures 15.

Figure 2 also illustrates that the I/O terminals 8 are spaced apart at wider distances than the microbumps 15 on the IC to be tested. This spacing difference is preferably much higher than shown in the drawing. Preferably the I/O terminals form a regular array with a given pitch that is considerably larger than the pitch between the microbumps, up to hundreds of micrometers or even millimeters. This facilitates access to the I/O terminals by the test equipment. It is an advantage of the invention that this 'fan-out routing' from a narrow pitch of the microbumps 15 to a wider pitch of the I/O terminals 8 can be realized. In the embodiment of Figure 2, this is done by suitable routing of conductors in the IC portion 6, as schematically illustrated by the shape of the conductors 21. Alternatively, the TSVs 9 may be formed above each unit cell 14 (i.e. at the same pitch as the bumps 15), and a redistribution layer may be produced on the backside of the substrate 1 (the side at the top of the drawing in Figure 2a). A re-distribution layer is a known concept, realizable for example by BEOL process steps, wherein via connections are re-routed laterally in the substrate to other contact areas. The I/O terminals are then formed on the contact areas, situated at wider intermediary distances than the TSVs 9. According to other embodiments, 'fan-out routing' in the IC portion 6 may be combined with a redistribution layer on the back side of the substrate 1.

The device of the invention may be built into a probe station in any manner known in the art. Preferably the device is connected to a probe card, by soldering or by screwing onto contact pads. The probe card is then mounted in a probe card holder. The positioning of the device under test relative to this probe card holder takes place by translational movements in two orthogonal directions. The probe card itself is connected to the test equipment.

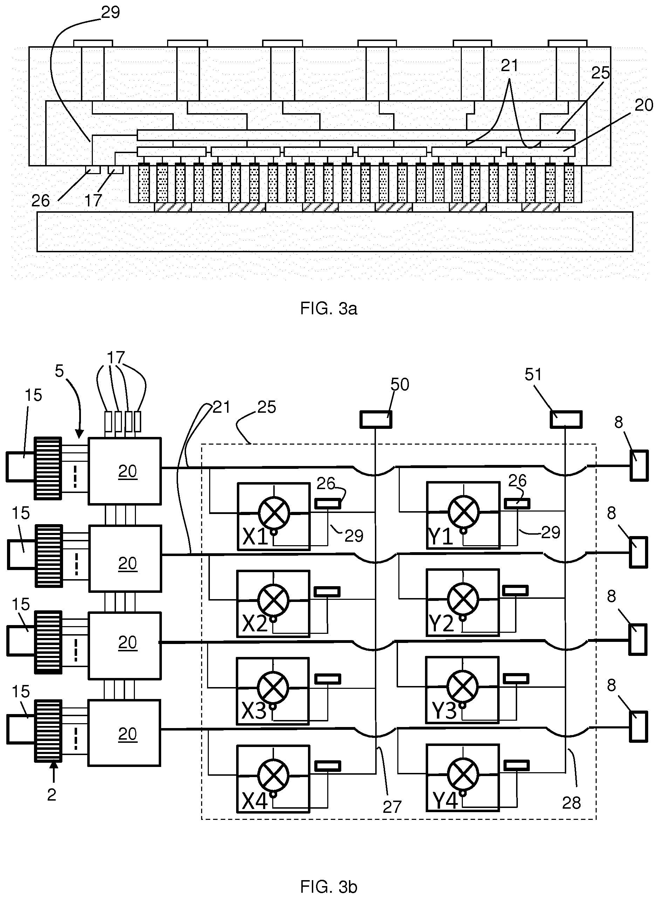

In addition to the selection circuitry 16/20, the IC portion 6 may comprise programming circuitry 25, as illustrated in Figure 3a. The programming circuitry is configured to enable interconnections between selected probes 5, and preferably comprises additional switches which are actuatable by control signals supplied through input terminals 26 and signal lines 29. An exemplary layout of the programming circuitry is shown in Figure 3b. Figure 3b is a schematic representation of connectivities and not a view of the actual device. Only four microbumps 15 are depicted, contacted by parts of the contactor 2, with 16 signals being transmitted through the probes 5 to each of the selection circuits 20, and with selection of probes being performed via the terminals 17. The programming circuitry 25 comprises two rows of pass-gates $X_i$ and $Y_i$, a pass-gate being connected between every I/O signal line 21 and one of two interconnect lines 27 and 28. Switching a selected number of the pass-gates $X_i$ and $Y_i$ on or off allows to interconnect internally a set of microbumps 15, and equally interconnect the I/O terminals 8 already connected to these microbumps. The layout of Figure 3b is merely an example and the skilled person is capable of applying other configurations, capable of enabling the interconnection of multiple probes. Terminals 26 and lines 29 are drawn within the rectangle which symbolizes the programming circuitry 25 in Figure 3b, but these features are to be regarded as outside of the programming circuitry as such (as seen in Figure 3a). Terminals 50/51 shown in Figure 3b are optional. Adding terminals 50/51 allows for instance to control the voltage at the points 50/51 by measuring the voltage and delivering the current through normal I/O terminals 8, using interconnect lines 27/28 as sense lines.

When the device is placed on the bumps 15, a mapping procedure is performed in order to map out which of the probes 5 is in physical contact with a bump 15. The bumps 15 may be identified by coordinates [x,y] and the probes 5 by coordinates (x,y), with x and y integer numbers starting from one and going up to the number of rows and columns in the respective arrays. According to a first embodiment, this mapping is done by an electrical mapping procedure. Two bumps, e.g. [1,1] and [2,1] are shorted, either in the design of the IC to be tested, or by an external connection between the bumps. Then, pairs of probes 5 are scanned, i.e. pairs of probes are selected by applying the required selection signals to the terminals 17 of the probing device. The test equipment then verifies whether the selected probes are shorted. When two shorted probes are found, these are registered as the matching probes for bump [1,1] and [2,1]. The scanned probe pairs can be chosen by taking into account the maximum possible misalignment between the first probe and the first bump, as well as the known difference between the bump pitch and diameter and the probe pitch and diameter. In the embodiment of Figure 2, systematically probe pairs can be chosen by selecting a probe in each of two neighbouring unit cells 14, i.e. by selecting probe pairs (x,y) and (x+4,y). The mapping of remaining probes and bumps can be easily made accordingly. Alternatively, electrical mapping can be done by performing conventional open-short tests on the IC under test The micro-bumps to be probed are the I/O doors to the IC-under-test. These I/Os will be equipped with I/O drivers for which conventional open/short tests can be performed, as is done at the start of virtually all IC tests. If such a test passes through one of the probes 5, it follows that that probe 5 is connected to the tested micro-bump 15.

According to another embodiment, an optical mapping method is applied. After landing the probing device on the IC to be tested, the relative shift from the first probe [1,1] and the first bump (1,1) can be detected by optical detection, measurement, and calculation. This can be realized by adding marks on the backside or front side of the substrate 1. Marks such as box-in-box, circles or crosses can be used, which are known in the art for determining misalignment, also known as overlay errors in semiconductor processing. Marks are also made on the IC to be tested. An imaging system based on an optical or infrared camera detects the marks on the substrate 1 and the device to be tested and calculates their relative distance. Because the distance between the marks and the first probe on the substrate 1 and the distance between the marks and the first bump 15 on the IC to be tested are known values accurately determined by design and manufacturing, the relative shift between the first probe on the probing device and the first bump on the device to be tested is easily calculated. This value is then used to make the mapping between the probe array on the probing device and the bump array to be tested. So a probing device according to the invention to which the above-described optical mapping method can be applied is provided with one or more marks that are detectable by an optical detection system.

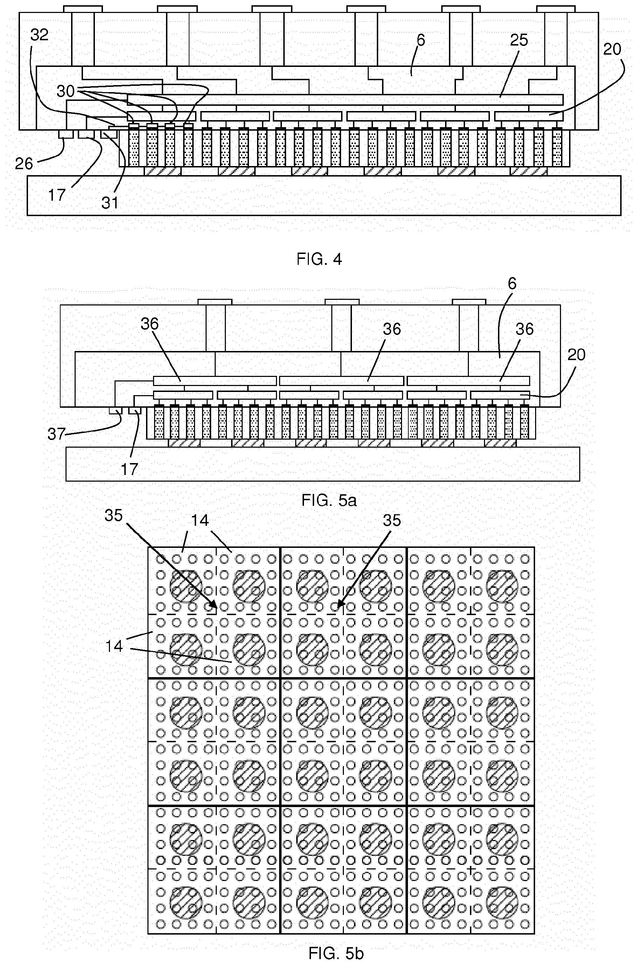

According to a third embodiment, a mechanical mapping method is applied. This requires a probing device of the invention equipped with an array of stress sensors in connection with at least a portion of the array of pads 7. Figure 4 illustrates the embodiment of Figure 2, further equipped with an array of stress sensors 30 , one sensor 30 being attached to each pad 7 of one unit cell 14. The stress sensors may be known devices based on transistors, capacitors, piezoelectric elements, or other mechanisms. One sensor 30 is provided above each pad 7 of the unit cell. The sensor array is produced as an additional part of the IC portion 6 of the device of the invention. The signals produced by the sensors are collected at output terminals 31, via conductor lines 32. When the device is placed on the IC to be tested with a given pressure, the output of the sensors 30 above the probes 5 which are in contact with a microbump 15 is higher than the output of the other sensors. This allows to define which probes are in contact with a bump 15. The mapping of the probes in the remaining unit cells is done on the basis of the known pitch of the probe array and of the bump array.

The IC portion 6 may comprise additional levels of selection circuits, in order to reduce the number of I/O terminals 8. This is illustrated in Figures 5a and 5b. Four unit cells 14 are grouped together to form one unit block 35. Each unit block is provided with a selection circuit 36 connected to one I/O terminal 8. Input terminals 37 are provided for supplying selection signals to the selection circuits 36. The unit blocks 35 can be selected and tested sequentially.

In the embodiments shown in Figures 1 to 5, contact terminals 17, 26 and 31 which are on the front side of the substrate 1, and the conductor lines 18, 29 and 32 connected thereto can alternatively be produced as contact terminals 8 at the back of the substrate 1, connected through TSVs 9.

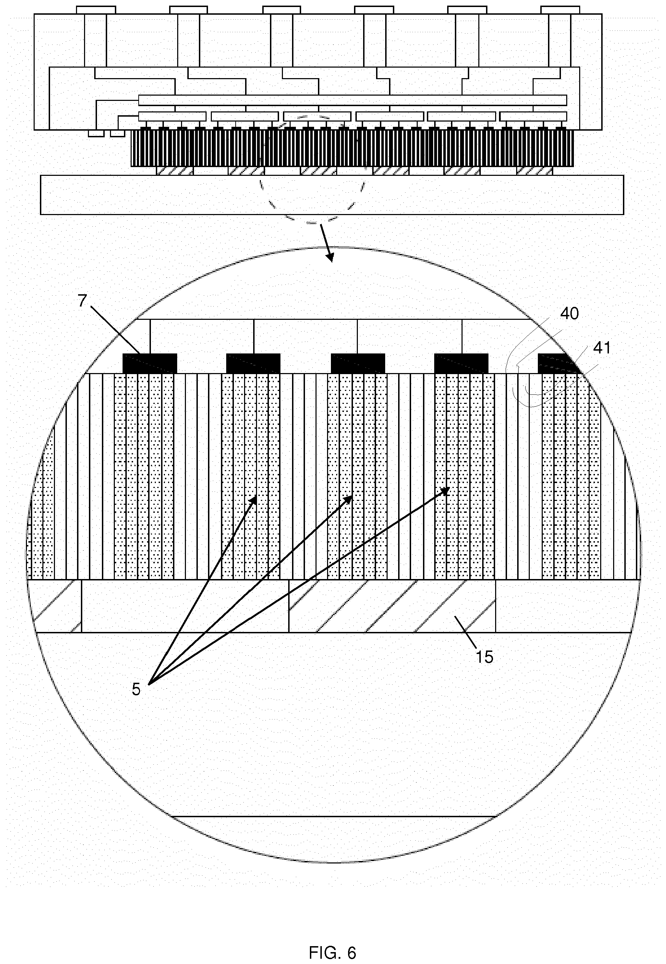

According to an embodiment illustrated in Figure 6, the anisotropically conducting contactor 2 comprises a densely arranged multitude of nano-scaled electrical conductors 40 oriented essentially perpendicularly with respect to the upper and lower surface of the contactor. These conductors are embedded in a matrix of non-conductive material 41, for example a polymer. The conductors are thus individually isolated from each other by the embedding non-conductive material. Each of the contact pads 7 is in electrical and physical contact with a number of nano-scaled conductors 40, thereby creating parallel conductive probes 5 between the upper and lower surface of the contactor 2, each probe 5 contacting one of the pads 7, each probe formed by a group of nano-conductors. The conductors that are not in contact with a pad 7 are not capable of conducting a current towards the IC portion 6, hence these conductors act as isolating portions between the 'probes' 5. This embodiment is advantageous because the probes 5 are self-aligned to the pads 7. The nano-conductors can for example be metallic nanowires electroplated in anodic aluminium oxide (AAO) templates, carbon nanotubes (CNTs), or carbon nanofibers (CNFs), all of which are existing technologies. The production of gold nanowires in an AAO template is described in "Fabrication and characterization of a flow-through nanoporous gold nanowire/AAO composite membrane", Liu et al, Nanotechnology 19 (2008) 335604 (6pp). The production of a contactor 2 comprising CNTs embedded in polydimethylsiloxane (PDMS) is described in "Aligned Carbon Nanotube-Polymer Hybrid Architectures for Diverse Flexible Electronic Applications", Yung Joon Jung et al, Nano Letters, 2006, Vol. 6, nr. 3, 413-418.

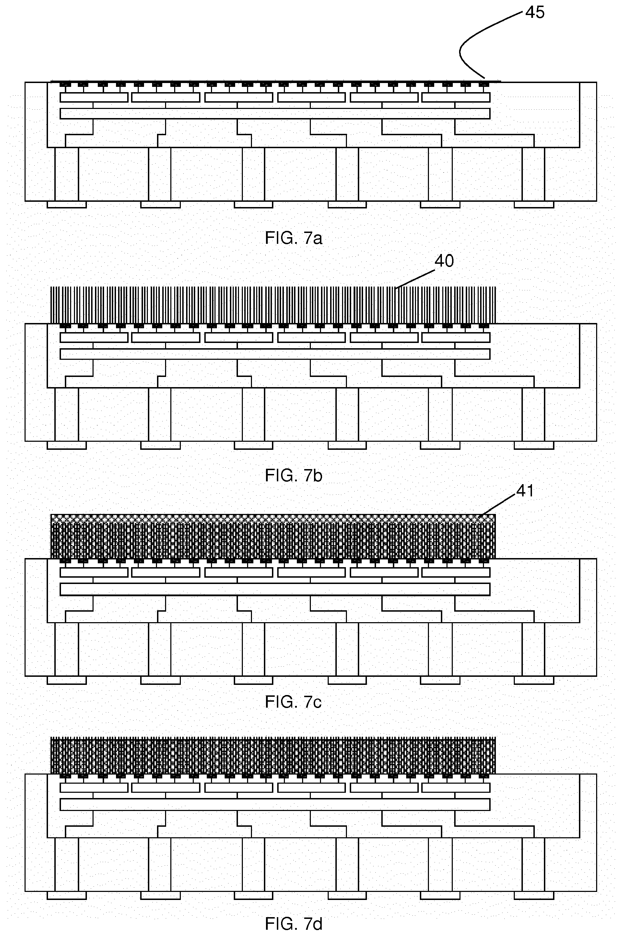

The contactor 2 according to the latter embodiment may be produced directly on the IC portion 6 of the substrate 1, as illustrated in Figures 7a-7d. First a catalyst layer 45 is deposited on the surface of the IC portion, covering all the pads 7 (Fig. 7a). Then nanowires or nanotubes 40 are grown on the catalyst layer according to a known process, thereby forming a forest of upstanding wires or tubes (Fig. 7b). Then an insulating material 41 is infiltrated between the individual wires or tubes (Fig. 7c) e.g. a polymer is poured over the wires or tubes and cured to form a polymer matrix wherein the wires or tubes are each individually embedded. Preferably an etch step is performed to etch back the insulating material slightly with respect to the ends of the wires or tubes, so as to improve the contact of the wires or tubes with the micro-bumps of an IC under test (Fig. 7d). Alternatively, the contactor 2 may be produced by performing the steps shown in Figure 7 on an carrier substrate. The contactor is then bonded to the IC portion 6 by flipping the carrier substrate and bonding the contactor to the IC portion 6, using the adhesive properties of the polymer if a polymer is used as the insulating material, after which the carrier substrate is released.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

Unless specifically specified, the description of a layer being present, deposited or produced 'on' another layer or substrate, includes the options of

- said layer being present, produced or deposited directly on, i.e. in physical contact with, said other layer or substrate, and
- said layer being present, produced or deposited on one or a stack of intermediate layers between said layer and said other layer or substrate.

**Claims**

1.    A probing device for electrical testing of an integrated circuit, the IC to be tested comprising an array of contact structures (15), the probing device comprising :

• a semiconductor substrate (1) comprising a plurality of input/output (I/O) terminals (8,50,51) and an integrated circuit (IC) portion (6) comprising an array of contact pads (7) on a surface of the substrate,
• a contactor (2) attached to the IC portion (6) of the substrate, the contactor comprising an attachment surface (3) and a contact surface (4), and an array of conductive probes (5) extending between the two surfaces, the array of probes being in physical and electrical contact with the array of contact pads (7), and wherein the contact surface of the contactor is configured to be placed on the IC to be tested (11) by establishing a physical and electrical contact between the contact structures (15) on the IC to be tested and a number of the probes (5),

wherein the IC portion (6) of the substrate comprises circuitry (16,20) for selecting individual probes (5) and establishing a connection between a selected probe (5) and one or more I/O terminals (8).

2.    The probing device according to claim 1, wherein a number of adjacent probes (5) are grouped in a number of unit cells (14), and wherein the IC portion (6) comprises a selection circuit (20) for each unit cell, for selecting individual probes in each unit cell and establishing a connection between a selected probe (5) and one or more I/O terminals (8) .

3.    The probing device according to claim 2, wherein the selection circuit (20) comprises a multiplexed array of pass gates, a pass-gate being connected between each of the probes (5) and one or more I/O terminals (8), and wherein the substrate (1) comprises input terminals (17) and selection signal lines (18) for carrying a set of digital selection signals to the selection circuit (20).

4. The probing device according to claim 3, wherein the substrate (1) comprises selection signal lines (18) which are common to several unit cells (14), so that one set of selection signals may be used to select probes (5) in a plurality of the selection circuits (20).

5. The probing device according to any one of the preceding claims, wherein the IC portion (6) of the substrate (1) further comprises circuitry (25) for enabling the interconnection of several selected probes (5).

6. The probing device according to any one of the preceding claims, wherein the contactor (2) comprises a plurality of nano-scaled electrical conductors (40) oriented along the same direction, and extending between the attachment surface (3) and the contact surface (4), the conductors being embedded in a matrix of an electrically insulating material (41), so that the contactor is electrically conductive only in the direction of the conductors (40), the attachment surface (3) of the contactor being attached to the IC portion (6) of the substrate so that a plurality of conductors (40) is in physical and electrical contact with each of the contact pads (7), each plurality of contacting conductors (40) forming a probe (5) extending between the two surfaces of the contactor (2).

7. The probing device according to any one of the preceding claims, wherein the substrate (1) comprises marks which are detectable by an optical or infrared detector.

8. The probing device according to any one of the preceding claims, wherein the IC portion (6) of the substrate (1) further comprises a plurality of pressure sensors (30), each pressure sensor being configured to detect a pressure exerted on one of the probes (5).

9. The probing device according to any one of claims 2 to 8, wherein several unit cells (14) are grouped in unit blocks (35), and wherein the IC portion (6) comprises a selection circuit (36) for each unit block.

10. A method for testing an integrated circuit under test by a probing device according to any one of the preceding claims, the IC under test comprising an array of contact structures (15) having a given pitch (p), wherein the pitch (s) of the array of probes (5) is smaller than the pitch (p) of the array of contact structures (15) on the IC to be tested, so that at least one probe (5) lands on a contact structure (15) when the probing device is placed on the IC to be tested.

11. A kit of parts comprising :

   • One or more ICs to be tested, each IC comprising an array of contact structures (15), the array being defined by a given pitch (p),
   • a probing device according to any one of claims 1 to 9, wherein the pitch of the array of probes (5) in the contactor (2) of the probing device is smaller than the pitch (p) of the array of contact structures of the one or more ICs to be tested, so that at least one probe (5) lands on a contact structure (15) when the probing device is placed on the IC to be tested.

12. Kit of parts according to claim 11, wherein the spacing between the I/O terminals (8) on the probing device is wider than the spacing between the contact structures (15) on the ICs to be tested.

13. A method for determining which probes are in physical contact with the contact structures of an IC under test, when the probing device according to any one of claims 1 to 9 is placed on the IC, the method comprising the steps of

   - electrically shorting two contact structures (15),
   - selecting pairs of probes (5) on the probing device, and checking whether the probes of the selected pair are shorted,
   - if the probes are shorted, concluding that the selected probes are in physical and electrical contact with the shorted contact structures (15).

14. A method for determining which probes are in physical contact with the contact structures of an IC under test, when the probing device according to claim 7 is placed on the IC, the method comprising the steps of

   - detecting one or more marks on the probing device,
   - detecting one or more marks on the IC under test,
   - determining the distance between the marks on the probing device and the marks on the IC under test,
   - determining on the basis of said distance which probes are in contact with one of the contact structures (15) of the IC under test.

15. A method for determining which probes are in physical contact with the contact structures of an IC under test, when the probing device according to claim 8 is placed on the IC, the method comprising the steps of

   - detecting the output of the pressure sensors (30),

- determining on the basis of said output which probes are in contact with one of the contact structures (15) of the IC under test.

**Patentansprüche**

1. Sondierungsvorrichtung für elektrisches Testen einer integrierten Schaltung, wobei die zu testende IC ein Array von Kontaktstrukturen (15) umfasst, wobei die Sondierungsvorrichtung umfasst:

   - ein Halbleitersubstrat (1), das eine Vielzahl von Eingang/Ausgang- (I/O) Anschlüssen (8,50,51) und einen integrierten Schaltungs- (IC) -abschnitt (6) umfasst, der ein Array von Kontaktfeldern (7) auf einer Oberfläche des Substrats umfasst,
   - ein Schütz (2), das an den IC-Abschnitt (6) des Substrats befestigt ist, wobei das Schütz eine Befestigungsoberfläche (3) und eine Kontaktoberfläche (4) umfasst und ein Array leitfähiger Sonden (5), die sich zwischen den zwei Oberflächen erstrecken, wobei das Array von Sonden in physischem und elektrischem Kontakt mit dem Array von Kontaktfeldern (7) ist und wobei die Kontaktoberfläche des Schützes konfiguriert ist, auf der zu testenden IC (11) platziert zu werden, indem ein physischer und elektrischer Kontakt zwischen den Kontaktstrukturen (15) an der zu testenden IC und einer Anzahl der Sonden (5) eingerichtet wird,

   wobei der IC-Abschnitt (6) des Substrats Schaltkreise (16,20) zum Auswählen individueller Sonden (5) und Einrichten einer Verbindung zwischen einer ausgewählten Sonde (5) und einem oder mehreren I/O-Anschlüssen (8) umfasst.

2. Sondierungsvorrichtung nach Anspruch 1, wobei eine Anzahl von angrenzenden Sonden (5) in einer Anzahl von Einheitszellen (14) gruppiert ist und wobei der IC-Abschnitt (6) eine Auswahlschaltung (20) für jede Einheitszelle umfasst, um individuelle Sonden in jeder Einheitszelle auszuwählen und eine Verbindung zwischen einer ausgewählten Sonde (5) und einem oder mehreren I/O-Anschlüssen (8) einzurichten.

3. Sondierungsvorrichtung nach Anspruch 2, wobei die Auswahlschaltung (20) ein gemultiplextes Array von Durchleitungsgates umfasst, wobei ein Durchleitungsgate zwischen jeder der Sonden (5) und einem oder mehreren I/O-Anschlüssen (8) verbunden ist und wobei das Substrat (1) Eingangsanschlüsse (17) und Auswahlsignalleitungen (18) zum Tragen eines Satzes digitaler Auswahlsignale zu der Auswahlschaltung (20) umfasst.

4. Sondierungsvorrichtung nach Anspruch 3, wobei das Substrat (1) Auswahlsignalleitungen (18) umfasst, die sich einige Einheitszellen (14) teilen, sodass ein Satz von Auswahlsignalen verwendet werden kann, um Sonden (5) in einer Vielzahl der Auswahlschaltungen (20) auszuwählen.

5. Sondierungsvorrichtung nach einem der vorstehenden Ansprüche, wobei der IC-Abschnitt (6) des Substrats (1) weiter Schaltkreise (25) zum Ermöglichen der Zwischenverbindung einiger ausgewählter Sonden (5) umfasst.

6. Sondierungsvorrichtung nach einem der vorstehenden Ansprüche, wobei das Schütz (2) eine Vielzahl von nanoskalierten elektrischen Leitern (40) umfasst, die entlang derselben Richtung ausgerichtet sind und sich zwischen der Befestigungsoberfläche (3) und der Kontaktoberfläche (4) erstrecken, wobei die Leiter in eine Matrix aus einem elektrisch isolierenden Material (41) eingebettet sind, sodass das Schütz nur in der Richtung der Leiter (40) elektrisch leitfähig ist, wobei die Befestigungsoberfläche (3) des Schützes an dem IC-Abschnitt (6) des Substrats befestigt ist, sodass eine Vielzahl von Leitern (40) in physischem und elektrischem Kontakt mit jedem der Kontaktfelder (7) ist, wobei jede Vielzahl von kontaktierenden Leitern (40) eine Sonde (5) bildet, die sich zwischen den zwei Oberflächen des Schützes (2) erstreckt.

7. Sondierungsvorrichtung nach einem der vorstehenden Ansprüche, wobei das Substrat (1) Markierungen umfasst, die von einem optischen oder infraroten Detektor detektierbar sind.

8. Sondierungsvorrichtung nach einem der vorstehenden Ansprüche, wobei der IC-Abschnitt (6) des Substrats (1) weiter eine Vielzahl von Drucksensoren (30) umfasst, wobei jeder Drucksensor konfiguriert ist, einen Druck zu detektieren, der auf eine der Sonden (5) ausgeübt wird.

9. Sondierungsvorrichtung nach einem der Ansprüche 2 bis 8, wobei einige Einheitszellen (14) in Einheitsblöcken (35) gruppiert sind und wobei der IC-Abschnitt (6) eine Auswahlschaltung (36) für jeden Einheitsblock umfasst.

10. Verfahren zum Testen einer integrierten Schaltung unter Testung durch eine Sondierungsvorrichtung nach einem der vorstehenden Ansprüche, wobei die IC unter Testung ein Array von Kontaktstrukturen (15) umfasst, die eine gegebene Teilung (p) aufweisen, wobei die Teilung (s) des Arrays von Sonden (5) kleiner als die Teilung (p) des Arrays von Kontaktstrukturen (15) auf der zu testenden IC ist, sodass mindestens eine Sonde (5) auf einer Kontaktstruktur (15) landet, wenn die Sondierungsvorrichtung auf der zu testenden IC platziert wird.

11. Kit von Teilen, umfassend:

- eine oder mehrere zu testende ICs, wobei jede IC ein Array von Kontaktstrukturen (15) umfasst, wobei das Array durch eine gegebene Teilung (p) definiert ist,
- eine Sondierungsvorrichtung nach einem der Ansprüche 1 bis 9, wobei die Teilung des Arrays von Sonden (5) in dem Schütz (2) der Sondierungsvorrichtung kleiner als die Teilung (p) des Arrays von Kontaktstrukturen der einen oder mehreren zu testenden ICs ist, sodass mindestens eine Sonde (5) auf einer Kontaktstruktur (15) landet, wenn die Sondierungsvorrichtung auf der zu testenden IC platziert wird.

12. Kit von Teilen nach Anspruch 11, wobei der Abstand zwischen den I/O-Anschlüssen (8) an der Sondierungsvorrichtung weiter als der Abstand zwischen den Kontaktstrukturen (15) an den zu testenden ICs ist.

13. Verfahren zur Ermittlung, welche Sonden in physischem Kontakt mit den Kontaktstrukturen einer IC unter Testung sind, wenn die Sondierungsvorrichtung nach einem der Ansprüche 1 bis 9 auf der IC platziert ist, wobei das Verfahren die Schritte umfasst zum

- elektrischen Kurzschließen zweier Kontaktstrukturen (15),
- Auswählen von Paaren von Sonden (5) an der Sondierungsvorrichtung und Prüfen, ob die Sonden des ausgewählten Paares kurzgeschlossen sind,
- falls die Sonden kurzgeschlossen sind, Schlussfolgern, dass die ausgewählten Sonden in physischem und elektrischem Kontakt mit den kurzgeschlossenen Kontaktstrukturen (15) sind.

14. Verfahren zur Ermittlung, welche Sonden in physischem Kontakt mit den Kontaktstrukturen einer IC unter Testung sind, wenn die Sondierungsvorrichtung nach Anspruch 7 auf der IC platziert ist, wobei das Verfahren die Schritte umfasst zum

- Detektieren einer oder mehrerer Markierungen an der Sondierungsvorrichtung,
- Detektieren einer oder mehrerer Markieren an der IC unter Testung,
- Ermitteln der Distanz zwischen den Markierungen an der Sondierungsvorrichtung und den Markierungen an der IC unter Testung,
- Ermitteln auf der Basis der Distanz, welche Sonden in Kontakt mit einer der Kontaktstrukturen (15) der IC unter Testung sind.

15. Verfahren zur Ermittlung, welche Sonden in physischem Kontakt mit den Kontaktstrukturen einer IC unter Testung sind, wenn die Sondierungsvorrichtung nach Anspruch 8 auf der IC platziert ist, wobei das Verfahren die Schritte umfasst zum

- Detektieren des Ausgangs der Drucksensoren (30),
- Ermitteln auf der Basis des Ausgangs, welche Sonden in Kontakt mit einer der Kontaktstrukturen (15) der IC unter Testung sind.

**Revendications**

1. Dispositif de sondage pour test électrique d'un circuit intégré, l'IC à tester comprenant un réseau de structures de contact (15), le dispositif de sondage comprenant :

- un substrat semiconducteur (1) comprenant une pluralité de bornes (8, 50, 51) entrée/sortie (I/O) et une partie (6) de circuit intégré (IC) comprenant un réseau de plots de contact (7) sur une surface du substrat,
- un contacteur (2) fixé à la partie d'IC (6) du substrat, le contacteur comprenant une surface de fixation (3) et une surface de contact (4) et un réseau de sondes conductrices (5) s'étendant entre les deux surfaces, le réseau de sondes étant en contact physique et électrique avec le réseau de plots de contact (7), et dans lequel la surface de contact du contacteur est configurée pour être placée sur l'IC à tester (11) en établissant un contact physique et électrique entre les structures de contact (15) sur l'IC à tester et un certain nombre des sondes (5),

dans lequel la partie d'IC (6) du substrat comprend une circuiterie (16, 20) pour sélectionner des sondes individuelles (5) et établir une connexion entre une sonde sélectionnée (5) et une ou plusieurs bornes I/O (8).

2. Dispositif de sondage selon la revendication 1, dans lequel un certain nombre de sondes adjacentes (5) sont regroupées en un certain nombre de cellules unitaires (14), et dans lequel la partie d'IC (6) comprend un circuit de sélection (20) pour chaque cellule unitaire, pour sélectionner des sondes individuelles dans chaque cellule unitaire et établir une connexion entre une sonde sélectionnée (5) et une ou plusieurs bornes I/O (8).

3. Dispositif de sondage selon la revendication 2, dans lequel le circuit de sélection (20) comprend un réseau multiplexé de portes de passage, une porte de passage étant connectée entre chacune des sondes (5) et une ou plusieurs bornes I/O (8), et dans lequel le substrat (1) comprend des bornes d'entrée (17) et des lignes de signaux de sélection (18) pour transporter un ensemble de signaux de sélection numériques vers le circuit de sélection (20).

4. Dispositif de sondage selon la revendication 3, dans lequel le substrat (1) comprend des lignes de signaux de sélection (18) qui sont communes à plusieurs cellules unitaires (14), de sorte qu'un ensemble de signaux de sélection peut être utilisé pour sélectionner des sondes (5) dans une pluralité des circuits de sélection (20).

5. Dispositif de sondage selon l'une quelconque des revendications précédentes, dans lequel la partie d'IC (6) du substrat (1) comprend en outre une circuiterie (25) pour permettre l'interconnexion de plusieurs sondes sélectionnées (5).

6. Dispositif de sondage selon l'une quelconque des revendications précédentes, dans lequel le contacteur (2) comprend une pluralité de conducteurs électriques à échelle nanométrique (40) orientés le long de la même direction, et s'étendant entre la surface de fixation (3) et la surface de contact (4), les conducteurs étant embarqués dans une matrice d'un matériau électriquement isolant (41), de sorte que le contacteur est électriquement conducteur uniquement dans la direction des conducteurs (40), la surface de fixation (3) du contacteur étant fixée à la partie d'IC (6) du substrat de sorte qu'une pluralité de conducteurs (40) est en contact physique et électrique avec chacun des plots de contact (7), chaque pluralité de conducteurs de contact (40) formant une sonde (5) s'étendant entre les deux surfaces du contacteur (2).

7. Dispositif de sondage selon l'une quelconque des revendications précédentes, dans lequel le substrat (1) comprend des marques qui sont détectables par un détecteur optique ou infrarouge.

8. Dispositif de sondage selon l'une quelconque des revendications précédentes, dans lequel la partie d'IC (6) du substrat (1) comprend en outre une pluralité de capteurs de pression (30), chaque capteur de pression étant configuré pour détecter une pression exercée sur une des sondes (5).

9. Dispositif de sondage selon l'une quelconque des revendications 2 à 8, dans lequel plusieurs cellules unitaires (14) sont regroupées en blocs unitaires (35), et dans lequel la partie d'IC (6) comprend un circuit de sélection (36) pour chaque bloc unitaire.

10. Procédé de test d'un circuit intégré testé par un dispositif de sondage selon l'une quelconque des revendications précédentes, l'IC testé comprenant un réseau de structures de contact (15) ayant un pas donné (p), dans lequel le pas (s) du réseau de sondes (5) est inférieur au pas (p) du réseau de structures de contact (15) sur l'IC à tester, de sorte qu'au moins une sonde (5) se pose sur une structure de contact (15) lorsque le dispositif de sondage est placé sur l'IC à tester.

11. Kit de pièces comprenant :

- une ou plusieurs ICs à tester, chaque IC comprenant un réseau de structures de contact (15), le réseau étant défini par un pas donné (p),
- un dispositif de sondage selon l'une quelconque des revendications 1 à 9, dans lequel le pas du réseau de sondes (5) dans le contacteur (2) du dispositif de sondage est inférieur au pas (p) du réseau de structures de contact de l'une ou plusieurs ICs à tester, de sorte qu'au moins une sonde (5) se pose sur une structure de contact (15) lorsque le dispositif de sondage est placé sur l'IC à tester.

12. Kit de pièces selon la revendication 11, dans lequel l'espacement entre les bornes I/O (8) sur le dispositif de sondage est plus large que l'espacement entre les structures de contact (15) sur les ICs à tester.

13. Procédé pour déterminer quelles sondes sont en contact physique avec les structures de contact d'un IC testé, lorsque le dispositif de sondage selon l'une quelconque des revendications 1 à 9 est placé sur l'IC, le procédé comprenant les étapes consistant à

- court-circuiter électriquement deux structures de contact (15),
- sélectionner des paires de sondes (5) sur le dispositif de sondage, et vérifier si les sondes de la paire sélectionnée sont court-circuitées,
- si les sondes sont court-circuitées, conclure que les sondes sélectionnées sont en contact physique et électrique avec les structures de contact court-circuitées (15).

14. Procédé pour déterminer quelles sondes sont en contact physique avec les structures de contact d'un IC testé, lorsque le dispositif de sondage selon la revendication 7 est placé sur l'IC, le procédé comprenant les étapes consistant à

- détecter une ou plusieurs marques sur le dispositif de sondage,
- détecter une ou plusieurs marques sur l'IC testé,
- déterminer la distance entre les marques sur le dispositif de sondage et les marques sur l'IC testé,
- déterminer sur la base de ladite distance quelles sondes sont en contact avec une des structures de contact (15) de l'IC testé.

15. Procédé pour déterminer quelles sondes sont en contact physique avec les structures de contact d'un IC testé, lorsque le dispositif de sondage selon la revendication 8 est placé sur l'IC, le procédé comprenant les étapes consistant à

- détecter la sortie des capteurs de pression (30),
- déterminer sur la base de ladite sortie quelles sondes sont en contact avec une des structures de contact (15) de l'IC testé.

FIG. 1a

FIG. 1b

FIG. 2a

FIG. 2b

FIG. 3a

FIG. 3b

FIG. 4

FIG. 5a

FIG. 5b

FIG. 6

FIG. 7a

FIG. 7b

FIG. 7c

FIG. 7d

## REFERENCES CITED IN THE DESCRIPTION

**Patent documents cited in the description**

- US 20040032271 A

**Non-patent literature cited in the description**

- **LIU et al.** Fabrication and characterization of a flow-through nanoporous gold nanowire/AAO composite membrane. *Nanotechnology,* 2008, vol. 19 (335604), 6

- **YUNG JOON JUNG et al.** Aligned Carbon Nanotube-Polymer Hybrid Architectures for Diverse Flexible Electronic Applications. *Nano Letters,* 2006, vol. 6 (3), 413-418